# EUROPEAN PATENT APPLICATION

(11) **EP 0 969 238 A1**
(43) Date of publication of application: **05.01.2000**
(21) Application number: 98202183.4
(22) Date of filing: 29.06.1998
(51) Int. Cl.: F16L 21/06, F16L 23/08, F16L 37/08, C23C 14/34

(54) **Vacuum tight coupling for tube sections**

(71) Applicant: Sinvaco N.V., 9800 Deinze (BE)
(72) Inventor: Cnockaert, Dirk, 9800 Deinze (BE); De Bosscher, Wilmert, 9031 Drongen (BE); Lootens, Erwin, 9031 Drongen (BE); Verheyen, Pascal, 9890 Gavere (BE)
(74) Representative: Bird, William Edward

(57) **Abstract**

The invention relates to a vacuum tight coupling for the end portions (1,2) of two tubular sections, the size of the inner space of a first end portion (1) being smaller than that of the second end portion (2). The second end portion, with its flange extremity (11) can axially slide over the first end portion against an abutment ring (10) on said first end portion. The coupling includes at least one sealing ring (4,5) between said end portions and a clamping ring (3) with a substantially cylindrical outer surface. The ring (3) is composed of two substantially equal halves (12,13) with each a U-shaped cross section with an inwardly oriented recess (6), said recess enclosing said flange and said abutment ring (10) against each other. The two ring halves are fixed to each other at their extremities (15,16) and the fixing means comprises bolting means (9) in at least one place.

## Description

The invention relates to a vacuum tight coupling for the end portions of two tubular sections. In particular it relates to the coupling of heavy tube sections which have to rotate around their longitudinal tube axis such as eg. rotatable targets in vacuum sputtering reactors.

### Background of the invention

Vacuum or at least fluid tight couplings for tube ends are known from the patent publications DE 3328137; US 4,900,063; US 5,591,314; WO 85/04940 and EP 0726 417. Most of these coupling devices include clamping rings that, due to the nature of their fixing means, do not have a substantially cylindrical outer surface. This prevents tube rotation within a small opening surrounding -i.e. radially facing - the clamping rings. In addition, when joined, the transverse tube extremities essentially abut with their end faces against each other with sealing means positioned interbetween them in this transverse abutment area. When now one tube end has to carry the other heavy tube, eg. in cantilever mode and optionally has to set it in rotation, eg. at a considerable speed, then the structure of these known abutment-type couplings is subjected to virtually unsupportable stresses and loads.

### Object and brief description of the invention

It is an object of the invention to avoid these disadvantages and to provide a reliable vacuum tight coupling for relatively heavy tube sections. It is also an object to design such a coupling which permits rotation at relatively high speeds when needed. It is a further object to produce a coupling which can easily be assembled and disassembled and which is readily usable eg. as a spindle/target-coupling for a rotatable sputtering target. The spindle is then attached to its supporting unit, eg. an end block which is provided with the connections for driving and cooling the inner space of the target tube.

In the vacuum tight coupling for the end portions of two tubular sections according to the invention the size of the inner space of the first end portion is choosen smaller than that of the second end portion. This second end portion carries a radially outwardly extending flange extremity and can axially slide therewith over the first end portion against a peripheral outer abutment ring on said first end portion. At least one sealing ring is provided between said end portions in their overlapping cylindrical contact area. The coupling comprises further a clamping ring with a substantially cylindrical outer surface. This ring is composed of two substantially equal halves with each a U-shaped cross section with an inwardly oriented recess, said recess enclosing said flange and said abutment (circumferentially) against each other at their extremities. The fixing means for the ring halves comprise in at least one place bolting means, the axis of which is perpendicular to the longitudinal axis of the coupled tubular sections and substantially tangential to the clamping ring periphery.

To provide for a robust coupling, said overlapping cylindrical contact area, whereby one tube end enters the other, should exceed a minimum surface in relation to the inner diameter "d" of the first end portion. In this manner the entering tube end will offer a proper mechanical support for the surrounding tube end during any conditions of operation.

### Brief description of the drawings

The invention will now be described with reference to the attached drawings. Further details and advantages will be clarified, in particular in relation to certain preferred embodiments for couplings for spindles to rotatable targets.
Figure 1 is a longitudinal cross section view of a coupling according to the invention.
Figure 2 is a transverse cross section of figure 1 showing the clamping ring.
Figure 3 represents an alternative embodiment wherein, i.a. the flange extremity on the second end portion is a separate ring.
Figure 4 is again a cross section of figure 3.
Figures 5 and 6 show in cross section a different fixing arrangement for the two halves of the clamping ring.
Figure 7 relates to the insertion of a tubular section between first and second end portions of the coupling.

### Detailed description of certain embodiments

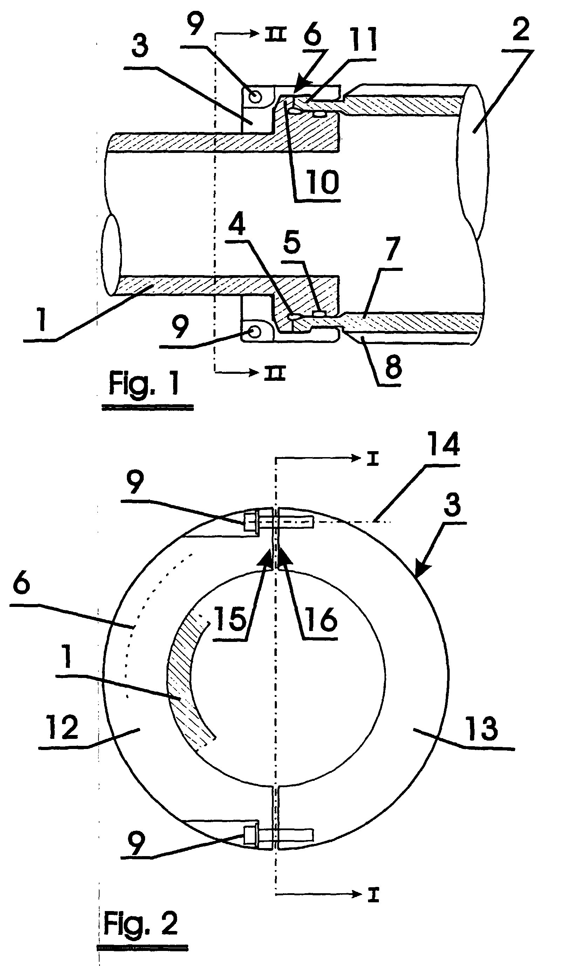

The vacuum tight coupling represented in figure 1 shows the end portions 1, 2 of two tubular sections. When applying the invention to a spindle/target- coupling, the first end portion 1 is part of the spindle and the second end portion 2 is part of the target tube. This target tube may have an inner support tube 7 onto which the cylindrical layer 8 of target material is fixed. The size of the inner space of the first end portion 1 is smaller than that of the second end portion 2. The second end portion 2 carries a flange extremity 11 which can axially slide with this portion over the first end portion 1 against a peripheral outer abutment ring 10 on said first end portion.

The coupling includes at least one sealing ring 4, 5 between said end portions in their overlapping contact area. The O-ring 5 is preferably arranged in a circumferential groove on the outside of the end portion of the spindle. The O-ring 4 is preferably located near the abutment area with the end portion of the target tube. Although one O-ring could in principle assure a vacuum tight sealing, two O-rings warrant a maximal vacuum integrity under the most extreme conditions of operation. Both O-rings 4 and 5 are mounted on the spindle during assembly. This arrangement provides an automatic and uniform pressure on the seal which minimises the risk of damaging them or the sealing surfaces during assembly, revision, cleaning and target exchange.

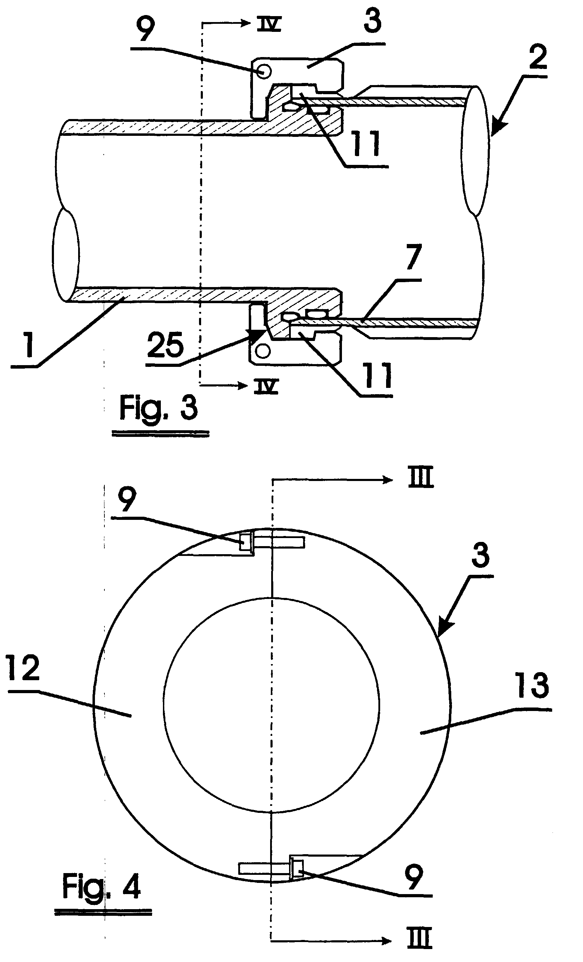

The coupling comprises further a clamping ring 3 with a substantially cylindrical outer surface. That means that the outer circumference of the ring with its fixing means 9 does not show parts which extend radially outside said circumference. As a result, cylindrical shields may be placed quite close over the clamp without touching them, even during rotation. The ring 3 is composed of two substantially equal halves 12, 13 with each a U-shaped cross section with an inwardly oriented recess 6. Upon closing the ring 3, said recess 6 encloses the flange 11 and said abutment 10 and forces thereby their transversal end faces tightly against each other by means of the conically machined edges (25 in figure 3). The two ring halves 12, 13 are fixed to each other at their extremities 15, 16.

The fixing means comprises in at least one place bolting means 9, the longitudinal axis 14 of which is perpendicular to the longitudinal axis of the coupled tubular sections and substantially tangential to the clamping ring periphery. This securing of the clamp halves together is done here with only two bolts which are screwed in threaded holes in the clamp end face 16. They can be reached and seen very easily in any position. This guarantees a fast and user friendly interface for mounting and removing a cylindrical tube, in particular a rotatable target. In this embodiment, as shown in figure 2, both bolts are thus fastened from the same side. This coupling system has thus not to be turned by 180° around its axis to couple the tube ends. When used for target-to-spindle couplings, the screw holes for the bolts are provided at the spindle side to prevent the sputtering of material onto the bolts.

In the embodiment of figures 3 and 4 the bolts 9 are oriented in opposite direction. In this manner each ring halve 13 is identical and thus replaceable by the opposite one 12. Figure 3 shows further the use of a separate flange ring 11 at the end of the overlapping tube section 2. This feature offers the advantage that the supporting tube 7 for the target does not need to be executed each time with a flange at its end. Separate flange rings 11 can be interposed that properly fit with the design ad hoc of tube end 2 and the cooperating clamping ring 3. The flange ring 11 is fixed to the tube end 2, e.g. by welding.

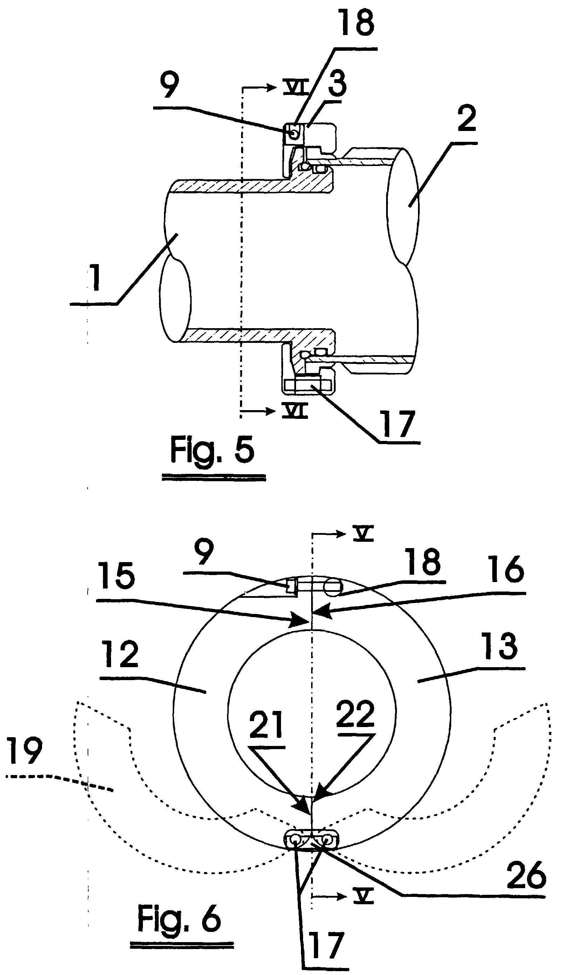

In figures 5 and 6 an alternative design of the clamping ring 3 is shown. The two ring halves 12 and 13 are pivotably linked to each other in one contact area of their extremities 21 and 22 by means of pivot pins 17 suitably mounted in a pivoting block 26. The two halves can be pivoted in an open position 19. The other extremities 15 and 16 are then suitably fixed to each other by a bolt 9 in an internally screw threaded bore 18.

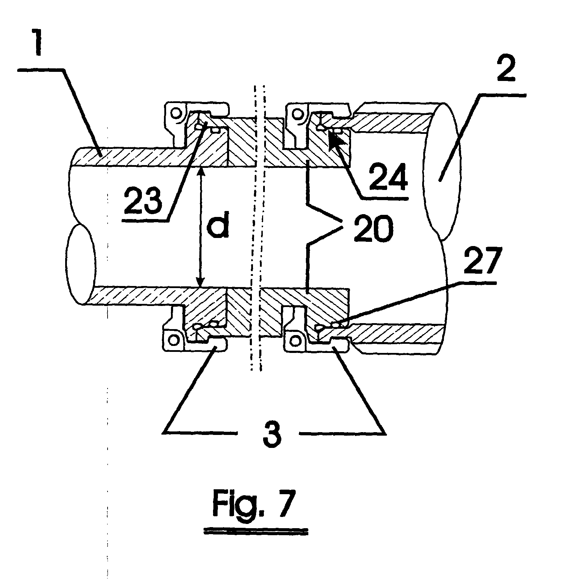

In certain vacuum chambers of sputtering reactors it is useful to provide for different sputtering widths. This corresponds to different lengths of the rotatable targets to be used. The active width of the sputtering area may thus be substantially shorter than the distance between the two opposite spindles which carry the target tubes. In this manner it is advantageous to provide at least one tubular insert section 20, as shown in figure 7, between spindle 1 and target tube 2. The transverse end 23 of the insert tube 20, that faces the first end portion 1 (spindle) is then again a ring which can slide axially over said first end portion. Likewise the opposite end 24 of the insert tube 20 is a ring over which said second end portion 2 can slide. This end is again provided with a suitable circumferential groove 27 for a sealing ring.

## Claims

1. A vacuum tight coupling for the end portions (1,2) of two tubular sections, the size of the inner space of a first end portion (1) being smaller than that of the second end portion (2), whereby the second end portion, with its flange extremity (11) can axially slide over the first end portion against a peripheral outer abutment ring (10) on said first end portion, the coupling including at least one sealing ring (4,5) between said end portions in their overlapping contact area and comprising a clamping ring (3) with a substantially cylindrical outer surface, composed of two substantially equal halves (12,13) with each a U-shaped cross section with an inwardly oriented recess (6), said recess enclosing said flange and said abutment against each other and whereby the two ring halves are fixed to each other at their extremities (15,16), the fixing means comprising in at least one place bolting means (9), the axis (14) of which is perpendicular to the longitudinal axis of the coupled tubular sections and substantially tangential to the clamping ring periphery.

2. A coupling according to claim 1 wherein said flange extremity (11) is a separate ring.

3. A coupling according to claim 1 whereby the ring halves, besides said bolting means (9) for fixing their extremities (15,16) in one place comprise pivoting means (17) for fixing them in their opposite extremities (21,22).

4. A coupling according to claim 1 whereby a tubular insert (20) is coupled between said first and second end portion, and whereby the insert end (23) facing the first end portion (1) is a ring which can slide axially over said first end portion whereas the opposite insert end (24) is a ring over which said second end portion (2) can slide.

5. An end block coupling for a rotatable sputtering target according to claim 1.
